Europäisches Patentamt

European Patent Office

Office européen des brevets

(19)

(11) Numéro de publication : **0 493 150 B1**

(12) **FASCICULE DE BREVET EUROPEEN**

(45) Date de publication du fascicule du brevet :
15.02.95 Bulletin 95/07

(51) Int. Cl.⁶ : **H03H 11/26**

(21) Numéro de dépôt : **91403222.2**

(22) Date de dépôt : **27.11.91**

(54) **Dispositif de retard réglable.**

(30) Priorité : **27.12.90 FR 9016339**

(43) Date de publication de la demande :
**01.07.92 Bulletin 92/27**

(45) Mention de la délivrance du brevet :
**15.02.95 Bulletin 95/07**

(84) Etats contractants désignés :
**BE CH DE ES FR GB IT LI NL SE**

(56) Documents cités :
**EP-A- 0 239 696
EP-A- 0 315 385
US-A- 4 422 052**

(73) Titulaire : **BULL S.A.
Tour BULL,
1, place Carpeaux
F-92800 Puteaux (FR)**

(72) Inventeur : **Marbot, Roland
121, avenue de Malakoff
F-75116 Paris (FR)**

(74) Mandataire : **Denis, Hervé et al
BULL S.A.
Tour BULL Cédex 74
PC/TB2803
F-92039 Paris La Défense (FR)**

EP 0 493 150 B1

# Description

L'invention a pour objet un dispositif de retard réglable. Elle s'applique notamment aux systèmes de transmission de données numériques à très haut débit, à plus de 1 gigabit par seconde par exemple.

Les dispositifs de retard actuels sont couramment faits de circuits RC. Le réglage du retard se fait par variation de la valeur de la résistance et/ou de la capacité. Dans un circuit intégré à transistors à effet de champ, de type MOS (Métal Oxyde Semiconducteur) par exemple, la résistance et la capacité sont ordinairement constituées par des transistors.

L'inconvénient de tels dispositifs à retard est la courbe de forme exponentielle de la variation du retard par rapport à la variation des valeurs de R et de C. La linéarité du réglage du retard nécessite donc des produits RC de grandes valeurs, incompatibles avec des temps de retard très courts. D'autre part, les circuits RC doivent être insérés entre des circuits tampons d'entrée et de sortie rendant les circuits extérieurs insensibles aux variations de R et de C. En outre, la technologie de fabrication des transistors à effet de champ produit de fortes dérives dans les caractéristiques des transistors de circuits intégrés différents. Ces dérives s'opposent à la fiabilité et à la finesse recherchés du réglage du retard.

L'invention présente un dispositif à retard réglable offrant les avantages de ne pas présenter une courbe de variation linéaire, de produire des retards très courts, de régler la valeur des retards de façon fine et fiable, et d'avoir une structure simple, bien adaptée à son intégration dans des circuits intégrés de type BiCMOS (Bipolar/Complementary MOS) et ne nécessitant pas de circuits tampons d'entrée et de sortie.

Un dispositif de retard réglable conforme à l'invention est caractérisé en ce qu'il comprend au moins un amplificateur différentiel dont la source de courant et les deux résistances de charge sont associées à un circuit de réglage faisant varier le courant de polarisation de façon hyperbolique et maintenant constant le produit de ce courant par chacune desdites résistances.

Les caractéristiques et avantages de l'invention ressortent clairement de la description qui suit, donnée à titre d'exemple et faite en référence aux dessins annexés.

Dans les dessins :
- la figure 1 est une vue schématique du circuit d'un mode de réalisation préféré d'un dispositif de retard réglable conforme à l'invention ;
- la figure 2 est un graphe illustrant la variation hyperbolique du courant de polarisation du dispositif de retard représenté sur la figure 1 ;
- la figure 3 est un graphe illustrant la variation linéaire du retard Θ produit par le dispositif représenté sur la figure 1 ;
- la figure 4 est une vue schématique d'un autre mode de réalisation d'un dispositif de retard conforme à l'invention ;
- la figure 5 est une vue synoptique d'une variante de réalisation d'un dispositif de retard conforme à l'invention, présentant un retard linéaire réglable sur une large gamme de variation ;
- la figure 6 (6A, 6B) est une vue schématique d'un exemple de réalisation du dispositif de retard représenté sur la figure 5 ;
- la figure 7 est un graphe illustrant une courbe de variation du retard produit par le dispositif illustré dans la figure 6 ; et
- la figure 8 est une vue synoptique d'une variante de réalisation d'un dispositif de retard conforme à l'invention, présentant un retard linéaire réglable sur une large gamme de variation.

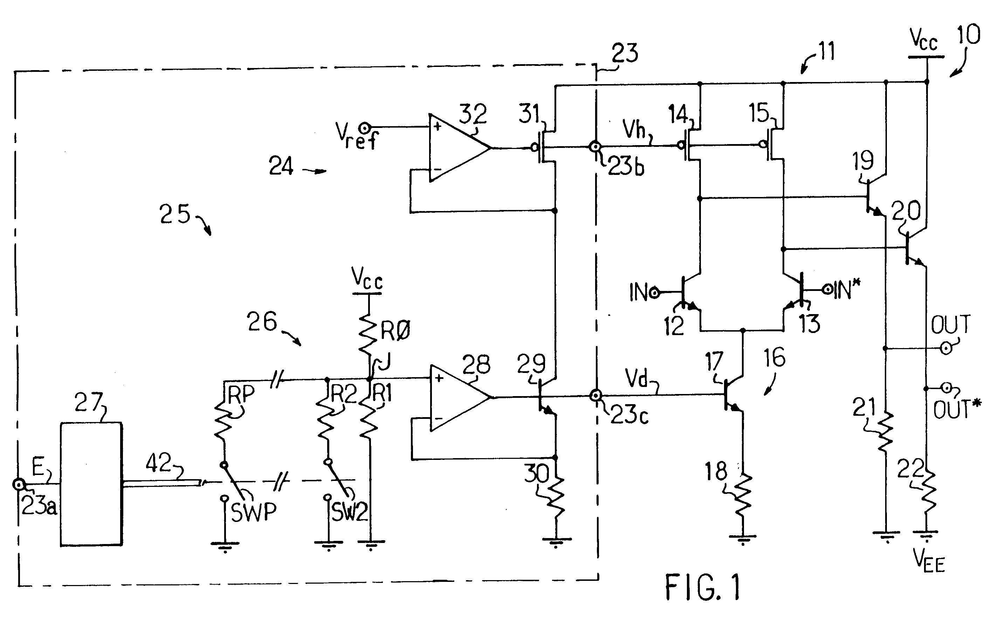

Sur la figure 1, le dispositif de retard 10 conforme à l'invention est fait à partir d'une porte ECL (Emitter-Coupled Logic) 11. Il est alimenté en tension entre les potentiels $V_{CC}$ et $V_{EE}$, valant respectivement + 5 Volts et la masse par exemple. Les deux transistors bipolaires d'entrée 12 et 13 de la porte 11 reçoivent respectivement sur leurs bases le signal d'entrée direct IN et le signal d'entrée inversé IN*. Leurs collecteurs sont reliés au potentiel $V_{CC}$ par l'intermédiaire de résistances de charge respectives 14 et 15. Leurs émetteurs sont réunis et reliés au potentiel $V_{EE}$ par une source de courant 16 faite d'un transistor bipolaire 17 et d'une résistance 18. Le transistor 17 a son collecteur connecté aux émetteurs des transistors 12 et 13, son émetteur connecté à la résistance 18 et sa base recevant un potentiel de réglage Vd. Les collecteurs des transistors 12 et 13 sont aussi connectés aux bases de deux transistors 19 et 20 formant deux amplificateurs de sortie à émetteur suiveur. Leurs collecteurs sont connectés au potentiel $V_{CC}$ et leurs émetteurs sont reliés au potentiel $V_{EE}$ par des résistances respectives 21 et 22 et délivrent les signaux de sortie direct OUT et inversé OUT*. De manière classique, les résistances sont faites de transistors respectifs de type MOS. Les résistances 14 et 15 sont faites de transistors PMOS ayant leurs trajets drain-source reliant le potentiel $V_{CE}$ aux collecteurs des transistors 12 et 13 respectifs et leurs grilles reliées à un potentiel de maintien Vh. En pratique, les résistances 18, 21 et 22 sont aussi ordinairement faites de transistors NMOS (non représentés) ayant leurs trajets drain-source reliant la masse aux émetteurs des transistors respectifs 17, 19 et 20 et leurs grilles mises à un potentiel prédéterminé.

Selon l'invention, la porte ECL 11 est associée à un circuit de réglage 23 faisant varier le courant de polarisation I produit par la source 16 de façon hyperbolique et maintenant à une valeur constante le produit de courant avec chacune des résistances de charge 14 et 15. Le circuit de réglage 23 a une borne d'entrée 23a et deux bornes de commande 23b et 23c. La borne d'entrée 23a reçoit un signal extérieur de commande E. Les bornes de commande 23b et 23c délivrent respectivement le potentiel de maintien Vh et le potentiel de réglage Vd. Le circuit de réglage 23 comprend un générateur de maintien 24 alimentant la borne de commande 23b, et un générateur de réglage 25 alimentant la borne de commande 23c et incorporant un diviseur de tension 26 et un générateur de commande 27. Le générateur de commande 27 reçoit le signal de commande extérieur E et produit P-1 signaux de sélection SS2-SSP (non représentés) acheminés par un bus 42. Le diviseur de tension 26 est disposé entre les potentiels $V_{CC}$ et $V_{EE}$ et se compose d'une résistance de base R0 en série avec une pluralité P de résistances R1-RP montées dans des branches parallèles respectives. Les P-1 résistances R2-RP sont sélectivement mises à la masse par des interrupteurs respectifs SW2-SWP commandés par les signaux de sélection SS2-SSP correspondants. La jonction des branches avec la résistance de base R0 forme le noeud J. Le générateur de réglage 25 comporte un amplificateur opérationnel 28 ayant son entrée positive connectée au noeud J, un transistor 29 et une résistance d'émetteur 30. Le transistor 29 a sa base connectée à la sortie de l'amplificateur opérationnel 28, son émetteur relié à la masse par l'intermédiaire de la résistance 30 et son collecteur relié au potentiel $V_{CC}$ par une résistance 31 formée d'un transistor PMOS. Le générateur de maintien 24 comprend un amplificateur opérationnel 32, dont l'entrée positive reçoit la tension de référence $V_{REF}$ et l'entrée négative est connectée au collecteur du transistor 29, et dont la sortie est appliquée sur les grilles des transistors PMOS constituant les résistances 14, 15 et 31.

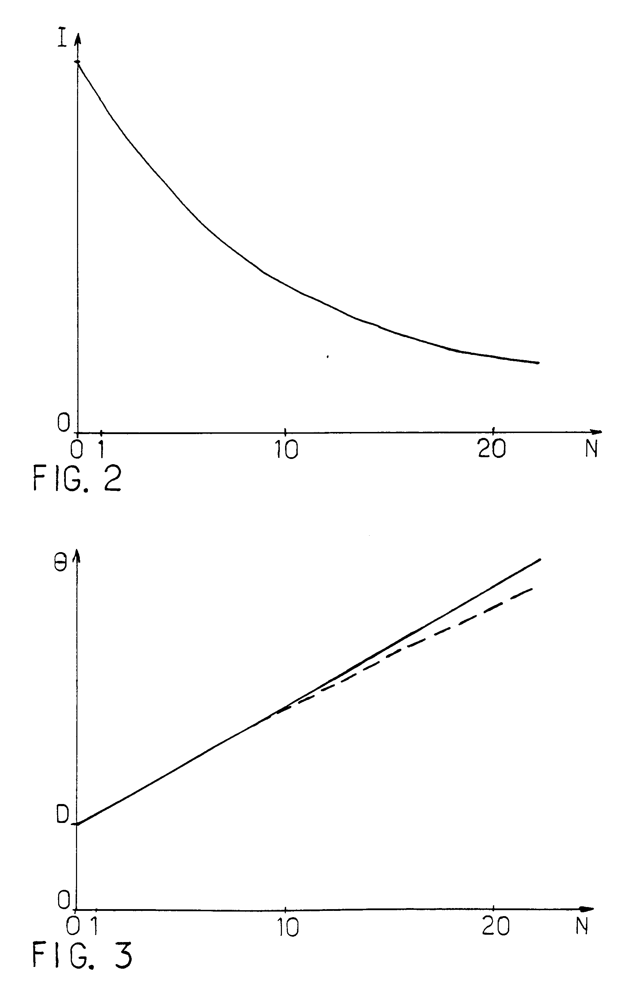

Le fonctionnement du dispositif de retard réglable 10 illustré dans la figure 1 va être fait en référence aux graphes des figures 2 et 3. Le graphe de la figure 2 représente les variations du courant de polarisation I produit par la source de courant 16 en fonction de la variation du nombre N de résistances mises en parallèle parmi les P résistances R1-RP du diviseur de tension 26. Ce diviseur de tension a ainsi la fonction d'un convertisseur numérique-analogique. Le graphe de la figure 3 représente les variations du retard $\theta$ des signaux de sortie OUT et OUT* par rapport aux signaux d'entrée IN et IN* en fonction des variations du nombre N. Le générateur de commande 27 détermine le nombre N en produisant N signaux de sélection SS2-SSN fermant les interrupteurs SW2-SWN. On désignera par R la valeur commune de chaque résistance, kR la valeur de la résistance de base R0 et $\beta$ le rapport R0/R1, où k et $\beta$ sont deux nombres positifs quelconques, et Rs la valeur de la résistance 18 de la source de courant 16, égale à celle de la résistance 30. Dans ces conditions, la tension de réglage Vd correspond à celle du point J, soit

$$Vd = V_{CC} / (kN + \beta + 1)$$

D'autre part, le générateur de maintien 24 assure le maintien de la tension Vh à une valeur telle que le potentiel sur les drains des transistors 14, 15 et 31 est égal à la tension de référence $V_{REF}$. Par conséquent, l'intensité I du courant traversant le transistor 29 ou le transistor 17 est

$$I = V_{CC} / Rs(kN + \beta + 1)$$

Le courant I varie donc selon une loi hyperbolique du type A/(BN + C), où A, B et C sont des coefficients prédéterminés. Une telle variation est représentée dans le graphe de la figure 2. Le tracé de la variation du retard $\Theta$ en fonction de N fait apparaître dans la figure 3 une ligne droite du type $\theta = CN + D$.

Le dispositif de retard 10 conforme à l'invention présente plusieurs avantages. L'avantage majeur est la variation linéaire du retard $\theta$ à des fréquences très élevées. La présence de transistors bipolaires comme éléments actifs dans la porte ECL 11 confère une fiabilité et une homogénéité des temps de retard $\theta$. Elle remédie aux problèmes de non homogénéité qui se présenteraient dans un amplificateur différentiel de type CMOS (Complementary MOS) à cause de la différence notable des retards dans les transistors NMOS et PMOS par rapport aux temps de retard très courts $\theta$ de la traversée du dispositif de retard 10, de l'ordre de 250 ps dans l'exemple illustré. Un autre avantage réside dans l'utilisation de signaux d'entrée complémentaires IN et IN* sur les bases des transistors 12 et 13 de la porte ECL 11. En effet, l'emploi du signal d'entrée IN et d'une tension de référence poserait un problème de centrage du front du signal IN sur la tension de référence à cause de la dispersion des caractéristiques des composants entre différents circuits intégrés. Un décalage du centrage produirait des retards $\theta$ non homogènes. Au contraire, dans l'exemple illustré, le centrage se fait sur le point de croisement des fronts des signaux d'entrée complémentaires, qui compense toute dérive et assure un temps de retard stable.

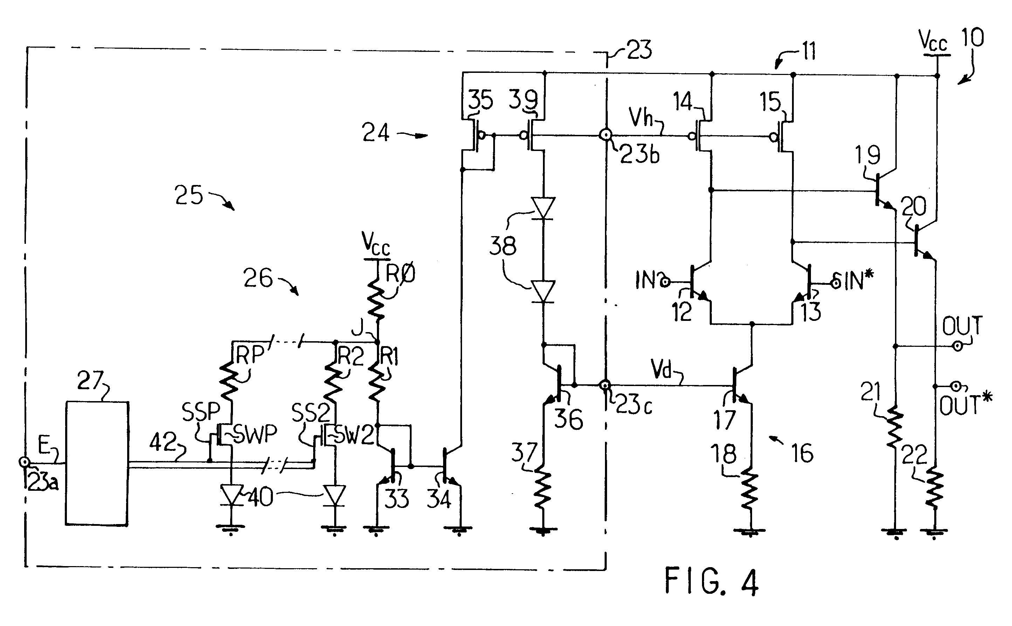

De nombreuses variantes peuvent être apportées par l'homme du métier à l'exemple de réalisation illustré. En particulier, l'expérience montre que la présence des amplificateurs opérationnels 28 et 32 augmente sensiblement le temps de réponse du dispositif de retard 10 et pose un problème d'oscillations parasites et un autre sur la réalisation du générateur de maintien 24 à cause de la large plage de variation de la tension d'entrée négative appliquée sur l'amplificateur opérationnel 32. Pour des fréquences très élevées, supérieures à 1 gigabit par seconde par exemple, le mode de réalisation représenté sur la figure 4 remédie à ces problèmes et constitue le mode de réalisation préféré de l'invention.

Le dispositif de retard 10 illustré dans la figure 4 utilise une porte ECL 11 et un circuit de réglage 23. Pour cette raison, les mêmes chiffres de référence désignent les mêmes fonctionnalités que dans le dispositif de retard représenté sur la figure 1. La différence essentielle réside dans la structure du générateur de maintien 24 et du générateur de réglage 25. Le diviseur de tension 26 comporte un transistor bipolaire 33 monté en diode, avec son émetteur à la masse et son collecteur connecté a sa base et relié au point J par la résistance de butée R1. Un transistor bipolaire 34 a son émetteur à la masse et son collecteur relié au potentiel $V_{CC}$ par le trajet drain-source d'un transistor PMOS 35 à grille et drain réunies délivrant le potentiel de maintien Vh. Un transistor bipolaire 36 monté en diode a son émetteur mis à la masse au travers d'une résistance 37, sa base commune avec celle du transistor 17 de la source de courant 16 de la porte ECL 11, et son collecteur relié au potentiel $V_{CC}$ successivement par deux diodes 38 et par une résistance 39 faite d'un transistor PMOS ayant sa grille connectée au potentiel de maintien Vh. La tension Vbe de la jonction base-émetteur du transistor 33 est compensée dans toutes les autres branches du diviseur de tension 26 par l'addition d'une jonction diode 40.

Le fonctionnement de principe du circuit de réglage 23 consiste à reproduire le courant I traversant la résistance R1 du diviseur de tension 26. Cette reproduction est d'abord faite par un premier miroir de courant composé des transistors 33 et 34. Ce miroir de courant forme avec le transistor 35 le générateur de maintien 24 fournissant la tension de maintien Vh aux résistances de charge 14, 15 et 39. Le courant I est ensuite reproduit par un second miroir de courant composé des transistors PMOS 35 et 39. Il est encore reproduit par un troisième miroir de courant composé des transistors 36 et 17. Ainsi, le courant I de la source de courant 16 est défini dans le diviseur de tension 26 par la résistance de butée R1 selon la formule

$$I = (V_{CC} - Vbe) / R1(kN + \beta + 1)$$

Ce courant I varie donc selon une loi hyperbolique du type A / (BN + C), similaire à celle représentée sur la figure 2. Le temps de retard $\Theta$ varie donc de la façon illustrée dans la figure 3. En pratique, la tension de maintien Vh fluctue légèrement à cause essentiellement de l'effet de la conductance de drain des transistors PMOS du second miroir de courant. Ce miroir n'est donc pas parfait et fait apparaître une légère variation (voltage swing) de la tension de collecteur des transistors 12 et 13 de la porte ECL 11. Le courant de polarisation I dans la porte 11 est donc légèrement déformé. Il en résulte une courbe de variation s'écartant progressivement de la ligne droite théorique, comme indiqué par un trait tireté dans la figure 3. Cependant, le dispositif de retard 10 illustré dans la figure 4 offre l'avantage d'être bien adapté aux très hautes fréquences et d'avoir une structure simple et facilement intégrable.

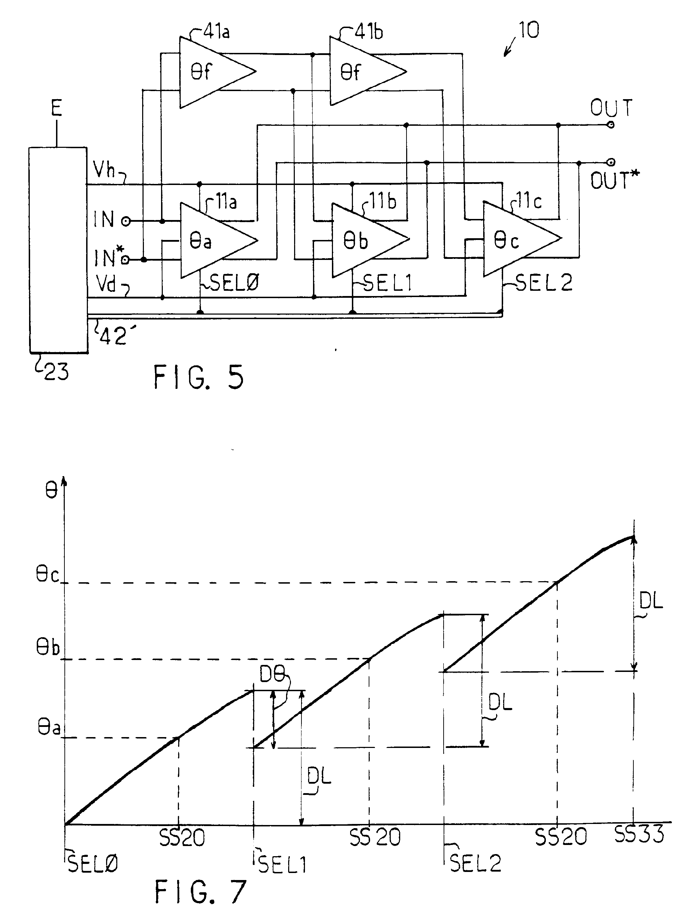

Les temps de retard $\Theta$ produits par les dispositifs 10 représentés sur les figures 1 et 4 peuvent être ainsi réglés linéairement dans une gamme maximale prédéterminée DL, de 250 ps par exemple. Si les temps de retard désirés vont au-delà des possibilités d'un simple dispositif de retard 10, il est aussi possible d'ajouter plusieurs portes ECL 11 de la façon illustrée sur la figure 5.

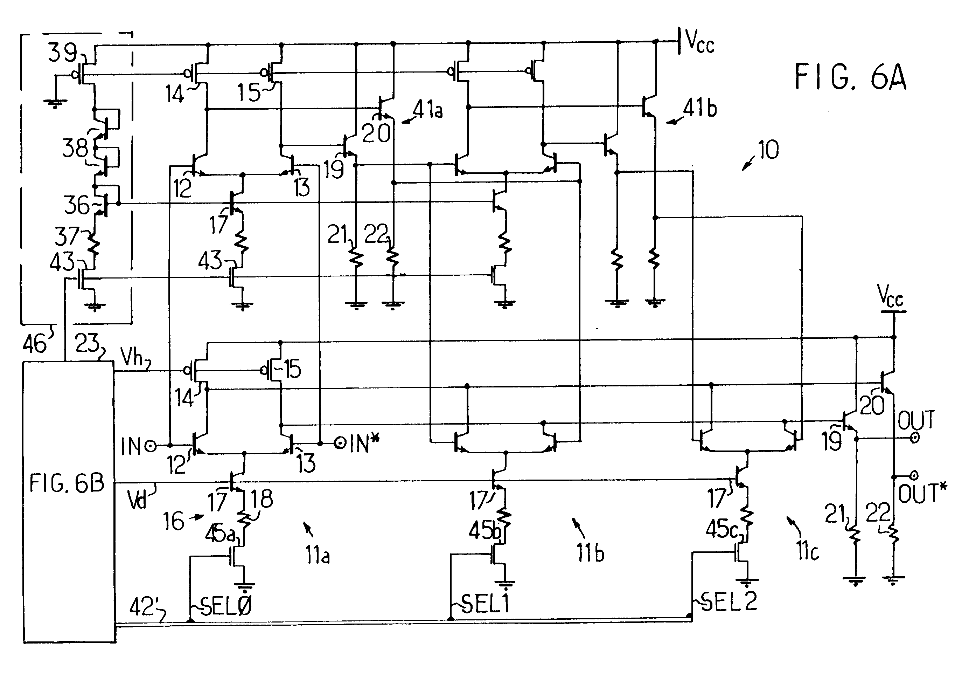

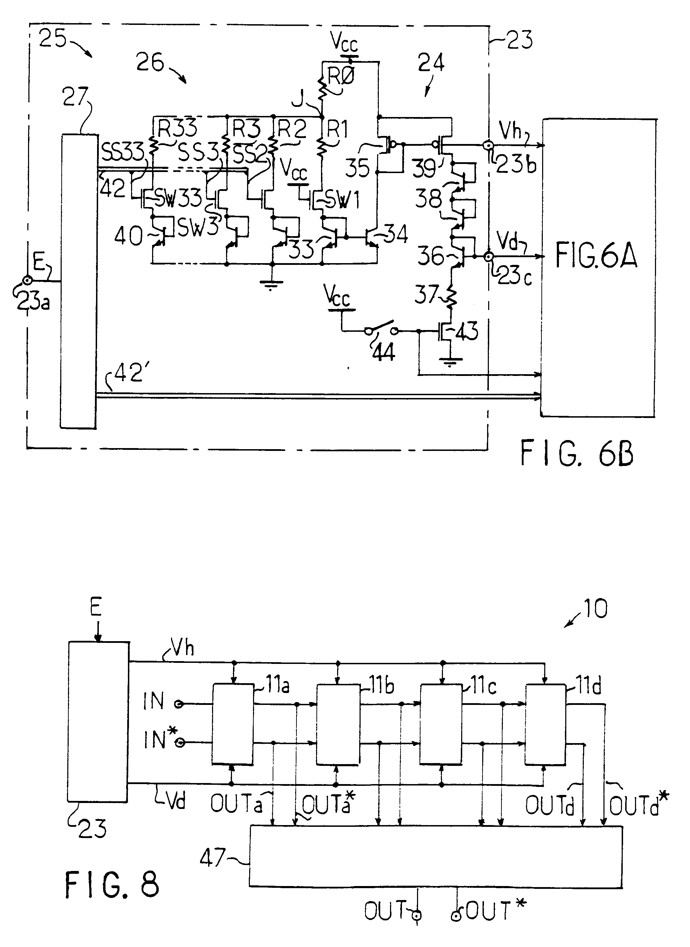

La figure 5 représente de façon synoptique la structure d'un dispositif de retard 10 conforme à l'invention qui offre l'avantage de retarder de façon sensiblement linéaire les signaux d'entrée dans une large gamme de valeurs. Ce dispositif de retard incorpore d'une manière générale plusieurs portes ECL. Dans l'exemple représenté sur la figure 5, le dispositif de retard 10 se compose de trois portes ECL 11a-11c à retard réglable et deux portes ECL 41a, 41b retardant leurs signaux d'entrée d'une même valeur fixe θf. Les portes 11a-11c sont commandées par le même circuit de réglage 23 et sont activées par des signaux de sélection respectifs SEL0-SEL2 acheminés par un bus 42' issu du circuit de réglage 23. La figure 6 (6A, 6B) illustre un exemple de réalisation préféré du dispositif de retard 10 représenté dans son principe sur la figure 5, et la figure 7 illustre une forme préférée de courbe de variation des retards en résultant. Les éléments qui ont des fonctions identiques, ou équivalentes dans les dispositifs de retard 10 représentés sur les figures 4, 5 et 6 portent les mêmes chiffres de référence.

Dans le dispositif de retard 10 de la figure 6 (6A, 6B), le circuit de réglage 23 a une structure similaire à celui de la figure 4. Plus précisément, le nombre maximal P de résistances pouvant être sélectionnées dans le diviseur de tension 26 est 32, référencées R2-R33 et sélectionnées par les interrupteurs respectifs SW2-SW33 réagissant aux signaux de sélection SS2-SS33 correspondants. Dans ces conditions, le générateur de commande 27 peut être simplement un registre à décalage de 32 bits pour la commande numérique des 32 interrupteurs. Chaque jonction diode 40 est constituée de manière classique par la jonction base-émetteur d'un transistor bipolaire. La résistance de butée R1 est aussi pourvue d'un interrupteur SW1 toujours fermé. Le circuit de réglage 23 inclut aussi les trois mêmes miroirs de courant 33, 34 ; 35, 39 ; 36, 17, la résistance 37 et les diodes 38. Il y est seulement ajouté un transistor NMOS 43 ayant sa source à la masse et sa grille au potentiel $V_{CC}$ par l'intermédiaire d'un interrupteur 44.

Les trois portes 11a-11c sont semblables à celle de la figure 4. Leurs deux transistors bipolaires 12, 13 se partagent les mêmes résistances de charge respectives 14, 15, faites de transistors PMOS ayant leurs grilles communes avec celles des transistors PMOS 35 et 39 et recevant ainsi la tension de maintien Vh fournie par la borne de commande 23b du circuit de réglage 23. Les sources de courant 16 des trois portes 11a-11c ont leurs transistors bipolaires 17 commandés par la tension de réglage Vd fournie par la borne de commande 23c du circuit de réglage 23.

Les résistances 18 sont montées en série avec des transistors NMOS respectifs 45a-45c ayant leurs sources à la masse et leurs grilles recevant les signaux de sélection respectifs SEL0-SEL2 fournis par le bus 42' connecté à une sortie du générateur de commande 27. Les collecteurs des transistors 12 et 13 dans les trois portes 11a-11c sont respectivement réunis aux bases des transistors 19 et 20 constituant avec les résistances 21 et 22 un circuit de sortie commun pour les trois portes 11a-11c.

Les deux portes 41a et 41b constituant des éléments de retard fixe sont associées à un générateur de référence 46 et ont chacune une structure similaire à celle des trois portes 11a-11c, de sorte que les mêmes composants portent les mêmes chiffres de référence. Le générateur de référence 46 a donc aussi une structure similaire à celle du montage en série 36, 37, 38, 39 et 43. Cependant, compte tenu du retard fixe qu'il commande, les grilles des transistors 39 et 43 du générateur 46 sont respectivement mises aux potentiels de la masse et, par l'intermédiaire de l'interrupteur 44, de $V_{CC}$. Les transistors 12 et 13 des portes 11a et 41a ont leurs bases respectives communes recevant les signaux d'entrée IN et IN*. Les bases des transistors 12 et 13 des portes 11b et 41b sont aussi communes. Les grilles des transistors PMOS de charge des transistors 12 et 13 dans les portes 41a et 41b sont communes avec celle du transistor 39 du générateur 46. Dans leurs sources de courant 16, les bases des transistors 17 sont communes avec celle du transistor 36 du générateur 46. Chaque source de courant 16 est aussi montée en série avec un transistor NMOS 43 ayant sa source à la masse et sa grille commune avec celle du transistor 43 du générateur 46. Les portes 41a et 41b sont aussi pourvues chacune d'un circuit de sortie identique à celui commun aux trois portes 11a-11c. Les sorties complémentaires du circuit de sortie de l'amplificateur 41a sont connectées aux bases respectives des transistors 12 et 13 des portes 11b et 41b. De même, les sorties complémentaires du circuit de sortie de la porte 41b sont connectées aux bases respectives des transistors 12 et 13 de la porte 11c.

Le principe du fonctionnement du dispositif de retard 10 ressort clairement des figures 5 et 7. Les portes 41a et 41b sont toujours activées et présentent chacune un même retard fixe θf déterminé par les tensions délivrées par le générateur 46. Les portes 11a-11c sont commandées par le circuit de réglage 23 pour faire varier chacune linéairement le retard θ dans une même gamme de valeurs DL (figure 7) et sont activées par les signaux de sélection SEL0-SEL2 correspondants issus du générateur de commande 27. Si le générateur de commande 27 active seulement la porte 11a, les signaux de sortie OUT et OUT* qu'elle délivre sont retardés d'un retard θa = θ compris dans la gamme DL (figure 7). Le dispositif de retard 10 fonctionne alors comme celui de la figure 4. Si seulement la porte 11b est activée pour un retard réglé sur la valeur θ (correspondant par exemple dans les trois cas au signal de sélection SS20), les signaux d'entrée IN et IN* traversent d'abord la porte 41a et sont donc retardés de la valeur fixe θf. Les signaux de sortie OUT et OUT* sont donc retardés de la valeur θb = θf + θ. Enfin, si seulement la porte 11c est activée pour un retard réglé sur la valeur θ, les signaux d'entrée IN et IN* traversent d'abord les portes 41a et 41b et sont donc retardés de la valeur fixe 2 θf. Les signaux de sortie OUT et OUT* sont donc retardés de la valeur θc = 2 θf + θ.

On comprend que la courbe de variation des retards fournis par le dispositif 10 serait linéaire si le retard fixe θf était égal à DL. Dans ce cas, cependant, une petite variation du retard autour du point de jonction de deux gammes de retards, θa et θb par exemple, obligerait le générateur 27 d'osciller pour activer les portes 11a et 11b correspondantes. Dans la figure 7, le retard θf a été choisi inférieur à la gamme DL, de sorte que la courbe générale a une forme en dents de scie. L'avantage de cette courbe réside dans les chevauchements Dθ entre les retards θa, θb et θc, qui permettent d'éviter toute oscillation du générateur 27. Par exemple, si le chevauchement Dθ correspond à environ la moitié d'une gamme DL, en fin d'une gamme DL le générateur de commande 27 peut commander avantageusement le retard à partir d'un point milieu sur la gamme suivante. Il est donc clair que la variation générale du retard produit par un tel dispositif de retard demeure linéaire malgré la courbe en forme de scie.

En pratique, la sélection des portes 11a-11c dans le dispositif de retard 10 représenté sur la figure 6 est faite en activant les transistors 45a-45c correspondants au moyen des signaux SEL0-SEL2 respectifs fournis par le générateur 27. Les transistors 45 agissent comme des interrupteurs pour que les portes ne consomment pas de courant lorsque le dispositif de retard 10 n'est pas activé dans un circuit intégré pouvant incorporer de nombreux autres dispositifs de retard 10, par exemple 32. Dans un tel circuit intégré, seulement les dispositifs de retard activés ont leur interrupteur 44 fermé.

Plus généralement, on comprend qu'une seule des portes 11a-11c pourrait être utilisée dans un dispositif de retard 10 du type représenté sur la figure 6. Dans ce cas, les circuits du dispositif de retard devraient être conçus pour que les signaux d'entrée IN et IN* soient retardés en traversant seulement ledit seul amplificateur (retard θa) et en option l'un au moins des amplificateurs à retard fixe θf. Il est ainsi clair que le nombre de retards fixes peut être quelconque. En conclusion, le fonctionnement de principe consiste à ajouter à un retard variable θ au moins un retard fixe θf au plus égal à la gamme DL de variation du retard θ. Comme variante du dispositif de retard 10 illustré dans la figure 6, les résistances de charge 14 et 15 ne seraient plus communes aux portes 11a-11c et pourraient avoir différentes valeurs dans les portes respectives. Dans ce cas, les gammes DL de ces portes auraient des valeurs et des pentes différentes, et chaque retard fixe θf devrait alors se référer à la valeur de la gamme DL qui le précède. La courbe générale pourrait donc prendre diverses formes non linéaires, par la combinaison de gammes de variation sensiblement linéaires.

Une variante de réalisation conforme à l'invention d'un dispositif de retard à large gamme de variation est illustrée dans la figure 8 de façon synoptique. Le dispositif de retard 10 incorpore quatre portes ECL 11a-11d montés en cascade. Les portes 11a-11d sont commandées par le même circuit de réglage 23 pour retarder successivement les signaux d'entrée IN et IN*. Leurs signaux de sortie OUTa-OUTd et OUTa*-OUTd* sont aussi appliqués sur les entrées respectives d'un multiplexeur 47, qui délivre les signaux de sortie complémentaires OUT et OUT* du dispositif de retard 10. Sachant qu'une porte peut produire une gamme de retards DL, dont un retard maximum de l'ordre de 250 ps, il est possible d'obtenir du dispositif de retard 10 un retard θ s'étalant jusqu'à un retard de l'ordre de 1 ns, qui correspond à une période de transmission d'un bit au débit d'1 gigabit par seconde. L'exemple d'assemblage de la figure 8 suffit à l'homme du métier pour en concevoir d'autres, plus ou moins performants selon les cas.

De nombreuses variantes peuvent être apportées aux exemples de réalisation illustrés. Il est clair notamment qu'au lieu d'une porte ECL illustrée, un simple amplificateur différentiel, à transistors bipolaires et/ou à transistors à effet de champ, pourrait dans certains cas suffire. L'avantage d'une porte ECL réside principalement dans ses retards très courts et dans ses performances aux hautes fréquences, dues à la non saturation de ses transistors 12 et 13 et à la faible variation de ses tensions de sortie (voltage swing) en fonction de la fréquence. Il ressort aussi de la description qui précède qu'un circuit de réglage 23 plus simple ou plus perfectionné pourrait faire varier les retards θ de façon plus ou moins dense, plus ou moins étalée et plus ou moins linéaire. D'une manière générale, la source de courant dans une porte ECL 11 ou dans un simple amplificateur différentiel de substitution pourrait n'inclure que la résistance 18. Dans ce cas, ou bien dans les cas illustrés, le réglage du courant de polarisation pourrait se faire en agissant sur la valeur de la résistance 18. On a vu aussi plus haut qu'une porte ECL, ou l'amplificateur différentiel de substitution, pourrait ne recevoir que le signal d'entrée direct IN, l'autre borne d'entrée étant appliquée à un potentiel fixe prédéterminé. Il est aussi possible pour l'homme du métier de faire varier le retard θ de façon continue.

## Revendications

1. Dispositif de retard réglable (10), caractérisé en ce qu'il comprend au moins un amplificateur différentiel (11) dont la source de courant (16) et les deux résistances de charge (14, 15) sont associées à un circuit de réglage (23) faisant varier le courant de polarisation de façon hyperbolique et maintenant constant le produit de ce courant par chacune desdites résistances.

2. Dispositif selon la revendication 1, caractérisé en ce que la source de courant incluant un transistor (17), les moyens de réglage agissent sur la tension de commande conduction de ce transistor.

3. Dispositif selon la revendication 2, caractérisé en ce que le circuit de réglage inclut un diviseur de tension (26) incluant un nombre P de résistances pouvant être sélectivement connectées en parallèle.

4. Dispositif selon la revendication 3, caractérisé en ce que le noeud (J) du diviseur de tension (26) est relié à une entrée d'un amplificateur opérationnel (28) dont la sortie commande la conduction du transistor (17) de la source de courant (16).

5. Dispositif selon l'une des revendications 1 à 4, caractérisé en ce que lesdites résistances de charge étant constituées par des transistors, le circuit de réglage inclut un amplificateur opérationnel recevant un potentiel de référence ($V_{REF}$) et commandant la conduction de ces transistors.

6. Dispositif selon la revendication 3, caractérisé en ce que l'une des résistances (R1) du diviseur de tension est associée à au moins un miroir de courant (33, 34 ; 35, 39 ; 36, 17) reliant le diviseur de tension à l'électrode de commande du transistor de la source de courant (16).

7. Dispositif selon la revendication 6, caractérisé en ce qu'un miroir de courant est fait de transistors à effet de champ (35, 39) constituant le générateur (24) de maintien à une valeur constante dudit produit du courant avec chacune des résistances de charge.

8. Dispositif selon la revendication 6 ou 7, caractérisé en ce qu'un miroir de courant inclut le transistor (17) de la source de courant (16).

9. Dispositif selon la revendication 1, caractérisé en ce que la source de courant incluant une résistance de charge (18), les moyens de réglage agissent sur la valeur de cette résistance pour faire varier le courant.

**10.** Dispositif selon l'une des revendications 1 à 9, caractérisé en ce que les deux entrées de l'amplificateur différentiel reçoivent les versions complémentaires d'un signal d'entrée (IN).

**11.** Dispositif selon l'une des revendications 1 à 10, caractérisé en ce que l'amplificateur différentiel forme une porte ECL.

**12.** Dispositif selon l'une des revendications 1 à 11, caractérisé en ce qu'il comporte plusieurs amplificateurs différentiels (11a-11d) dont les sorties respectives sont appliquées à un multiplexeur (47).

**13.** Dispositif selon l'une des revendications 1 à 12, caractérisé en ce que le retard variable produit par au moins ledit amplificateur différentiel est sélectivement ajouté à au moins un retard fixe ($\theta f$ - figures 6 et 7).

**14.** Dispositif selon la revendication 13, caractérisé en ce que le circuit de réglage produit une courbe en forme de dents de scie incluant plusieurs gammes de retards variables (DL) se chevauchant (D$\theta$).

**Patentansprüche**

**1.** Anordnung mit einstellbarer Verzögerung (10), dadurch gekennzeichnet, daß sie wenigstens einen Differenzverstärker (11) enthält, dessen Stromquelle (16) und dessen zwei Lastwiderstände (14, 15) mit einer Einstellschaltung (23) verbunden sind, die den Vorstrom hyperbolisch verändert und das Produkt dieses Stroms mit jedem der Widerstände konstant hält.

**2.** Anordnung gemäß Anspruch 1, dadurch gekennzeichnet, daß dann, wenn die Stromquelle einen Transistor (17) enthält, die Einstellmittel auf die Durchlaßsteuerspannung dieses Transistors einwirken.

**3.** Anordnung gemäß Anspruch 2, dadurch gekennzeichnet, daß die Einstellschaltung einen Spannungsteiler (26) enthält, der eine Anzahl (P) von Widerständen enthält, die wahlweise parallel geschaltet werden können.

**4.** Anordnung gemäß Anspruch 3, dadurch gekennzeichnet, daß der Knoten (J) des Spannungsteilers (26) mit einem Eingang eines Operationsverstärkers (28) verbunden ist, dessen Ausgangssignal den Durchlaß des Transistors (17) der Stromquelle (16) steuert.

**5.** Anordnung gemäß einem der Ansprüche 1 bis 4, dadurch gekennzeichnet, daß dann, wenn die Lastwiderstände durch Transistoren gebildet sind, die Einstellschaltung einen Operationsverstärker enthält, der ein Referenzpotential ($V_{REF}$) empfängt und den Durchlaß dieser Transistoren steuert.

**6.** Anordnung gemäß Anspruch 3, dadurch gekennzeichnet, daß einer der Widerstände (R1) des Spannungsteilers wenigstens einem Stromspiegel (33, 34; 35, 39; 36, 17) zugeordnet ist, der den Spannungsteiler mit der Steuerelektrode des Transistors der Stromquelle (16) verbindet.

**7.** Anordnung gemäß Anspruch 6, dadurch gekennzeichnet, daß ein Stromspiegel aus Feldeffekttransistoren (35, 39) gebildet ist, die den Generator (24) bilden, der das Produkt aus dem Strom und jedem der Lastwiderstände auf einem konstanten Wert hält.

**8.** Anordnung gemäß Anspruch 6 oder 7, dadurch gekennzeichnet, daß ein Stromspiegel den Transistor (17) der Stromquelle (16) enthält.

**9.** Anordnung gemäß Anspruch 1, dadurch gekennzeichnet, daß dann, wenn die Stromquelle einen Lastwiderstand (18) enthält, die Einstellmittel auf den Wert dieses Widerstandes einwirken, um den Strom zu verändern.

**10.** Anordnung gemäß einem der Ansprüche 1 bis 9, dadurch gekennzeichnet, daß die beiden Eingänge des Differenzverstärkers die komplementären Versionen eines Eingangssignals (IN) empfangen.

**11.** Anordnung gemäß einem der Ansprüche 1 bis 10, dadurch gekennzeichnet, daß der Differenzverstärker ein ECL-Gatter bildet.

**12.** Anordnung gemäß einem der Ansprüche 1 bis 11, dadurch gekennzeichnet, daß sie mehrere Differenzverstärker (11a-11d) enthält, deren jeweilige Ausgangssignale in einen Multiplexierer (47) eingegeben werden.

**13.** Anordnung gemäß einem der Ansprüche 1 bis 12, dadurch gekennzeichnet, daß die einstellbare Verzögerung, die wenigstens durch den Differenzverstärker erzeugt wird, wahlweise wenigstens einer festen Verzögerung ($\theta f$ - Fig. 6 und 7) hinzugefügt wird.

**14.** Anordnung gemäß Anspruch 13, dadurch gekennzeichnet, daß die Einstellschaltung eine Sägezahnkurve erzeugt, die mehrere sich über-

lappende (Dθ), veränderliche Verzögerungsbereiche enthält.

**Claims**

1. An adjustable delay device (10), characterised in that it comprises at least one differential amplifier (11), of which the current source (16) and the two load resistors (14, 15) are associated with a regulator circuit (23) causing the polarisation current to vary hyperbolically and maintaining constant the product of this current and each of said resistors.

2. A device according to Claim 1, characterised in that, the current source including a transistor (17), the regulating means act on the conduction control voltage of this transistor.

3. A device according to Claim 2, characterised in that the regulator circuit includes a voltage divider (26) including a number P of resistors which can be selectively connected in parallel.

4. A device according to Claim 3, characterised in that the node (J) of the voltage divider (26) is connected to an input of an operational amplifier (28), the output of which controls the conduction of the transistor (17) of the current source (16).

5. A device according to one of Claims 1 to 4, characterised in that, said load resistors being constituted by transistors, the regulator circuit includes an operational amplifier receiving a reference potential ($V_{REF}$) and controlling the conduction of these transistors.

6. A device according to Claim 3, characterised in that one of the resistors (R1) of the voltage divider is associated with at least one current mirror (33, 34; 35, 39; 36, 17) connecting the voltage divider to the control electrode of the transistor of the current source (16).

7. A device according to Claim 6, characterised in that a current mirror is made of field-effect transistors (35, 39) constituting the generator (24) for holding at a constant value said product of the current with each of the load resistors.

8. A device according to Claim 6 or 7, characterised in that a current mirror includes the transistor (17) of the current source (16).

9. A device according to Claim 1, characterised in that, the current source including a load resistor (18), the regulating means act on the value of this resistor to cause the current to vary.

10. A device according to one of Claims 1 to 9, characterised in that the two inputs of the differential amplifier receive the complementary versions of an input signal (IN).

11. A device according to one of Claims 1 to 10, characterised in that the differential amplifier forms an ECL gate.

12. A device according to one of Claims 1 to 11, characterised in that it comprises several differential amplifiers (11a-11d), the respective outlets of which are applied to a multiplexer (47).

13. A device according to one of Claims 1 to 12, characterised in that the variable delay produced by at least said differential amplifier is selectively added to at least one fixed delay (θf - Figures 6 and 7).

14. A device according to Claim 13, characterised in that the regulator circuit produces a saw-tooth shaped curve including several ranges of variable delays (DL) which overlap (Dθ).

FIG.1

FIG. 2

FIG. 3

FIG. 4

EP 0 493 150 B1

FIG. 5

FIG. 7

FIG. 6A

EP 0 493 150 B1

FIG. 6B

FIG. 8